# DEMANDE DE BREVET EUROPEEN

(11) **EP 3 241 702 A1**
(43) Date de publication de la demande: **08.11.2017**
(21) Numéro de dépôt: 17168733.8
(22) Date de dépôt: 28.04.2017
(51) Int. Cl.: B60K 35/00, B60K 37/06, H03K 17/96

(54) **PANNEAU DE COMMANDE POUR VEHICULE AUTOMOBILE**

(30) Priorité: 02.05.2016 FR 1653969
(71) Demandeur: Delphi Technologies, Inc., Troy, MI 48007-5052 (US)
(72) Inventeur: REISCHL, Erik, 55765 Birkenfeld (DE)
(74) Mandataire: Delphi France SAS

(57) **Abrégé**

Un panneau de commande pour véhicule automobile comprend une façade frontale (12) comportant au moins un pictogramme (16) indiquant une zone de commande (14); au moins un élément de détection capacitive (24) agencé contre la face arrière (40) de la façade frontale (12) et apposé en vis-à-vis du pictogramme (16); une carte à circuit imprimé (20); une source de lumière (22) montée sur la carte à circuit imprimé (20) et apte à produire un faisceau lumineux (44) de rétroéclairage vers le pictogramme. L'élément de détection capacitive (24) est une pièce plastique électriquement conductrice comprenant : une première partie formant une plaquette de détection (28) adjacente à la face arrière (40) de la façade frontale (12) apte à permettre une détection capacitive sur la zone de commande (14); une deuxième partie formant un guide de lumière (30) comprenant au moins une paroi (38) qui s'étend depuis la plaquette de détection (28) vers la carte à circuit imprimé (20) de manière à guider le faisceau lumineux (44) vers le pictogramme (16). L'élément de détection capacitive (24) est raccordé électriquement à la carte à circuit imprimé (20) par l'extrémité (42) de la paroi opposée à la plaquette de détection (28).

## Description

### DOMAINE TECHNIQUE

La présente invention concerne un panneau de commande automobile et plus particulièrement un panneau de commande rétroéclairé équipé de boutons capacitifs.

### ARRIERE-PLAN TECHNOLOGIQUE DE L'INVENTION

Des dispositifs de commandes ou panneau de commande à boutons capacitifs sont connus de l'art antérieur. De tels dispositifs comprennent généralement une façade frontale transparente peinte sur sa face arrière et présentant une pluralité de pictogrammes fonctionnels indiquant des zones spécifiques de commandes. Un film capacitif est apposé contre la face arrière de la façade frontale de sorte à ce que les zones de commandes forment des boutons de commandes capacitifs. Une carte électronique à circuit imprimé est reliée électriquement au film capacitif et comporte des moyens de contrôle du film capacitif. Pour assurer le rétroéclairage des pictogrammes, des diodes électroluminescentes sont agencées sur la carte à circuits imprimés. Généralement une entretoise est intercalée entre le film capacitif et la carte électronique à circuit imprimé, dans laquelle sont agencées des ouvertures rectangulaires disposées en regard des pictogrammes. Des montants s'étendent vers l'arrière depuis le pourtour de ces ouvertures, avec leurs extrémités libres qui reposent contre la carte électronique en entourant chacune des diodes électroluminescentes. Ces montants permettent de compartimenter le flux lumineux produits par les diodes et d'éviter la dispersion de lumière dans l'ensemble du panneau de commande.

Ce type de dispositif de commande à boutons capacitifs demande un assemblage complexe de différentes pièces de technologie différentes, notamment l'assemblage de pièces plastiques telles que la façade frontale, avec un film capacitif. Le film capacitif représente également une contrainte pour le rétroéclairage, notamment par ses propriétés de propagation de la lumière.

Le document EP2355356 A1 concerne un commutateur de contact et/ou de rapprochement capacitif. Le document US5917165A concerne un commutateur à effleurement avec capteur à touche.

Il est donc important de proposer une solution nouvelle résolvant ces problèmes.

### RESUME DE L'INVENTION

Un panneau de commande pour véhicule automobile comprend une façade frontale comportant au moins un pictogramme indiquant une zone de commande; au moins un élément de détection capacitive agencé contre la face arrière de la façade frontale et apposé en vis-à-vis du pictogramme; une carte à circuit imprimé; une source de lumière montée sur la carte à circuit imprimé et apte à produire un faisceau lumineux de rétroéclairage vers le pictogramme. L'élément de détection capacitive est une pièce plastique électriquement conductrice comprenant: une première partie formant une plaquette de détection adjacente à la face arrière de la façade frontale apte à permettre une détection capacitive sur la zone de commande; une deuxième partie formant un guide de lumière comprenant au moins une paroi qui s'étend depuis la plaquette de détection vers la carte à circuit imprimé de manière à guider le faisceau lumineux vers le pictogramme. L'élément de détection capacitive est raccordé électriquement à la carte à circuit imprimé par l'extrémité de la paroi opposée à la plaquette de détection.

L'élément de détection capacitive peut être une seule pièce surmoulée avec la façade frontale. L'élément de détection capacitive peut être une pièce plastique chargée de particules métalliques. Le guide de lumière peut être un conduit de lumière apte à diriger le faisceau lumineux vers le pictogramme. La plaquette de détection peut être opaque et peut comporter au moins une ouverture en vis-à-vis du pictogramme apte à laisser passer la lumière vers le pictogramme. La face arrière de la façade frontale comprend un renfoncement dans lequel la plaquette de détection est agencée. Une pièce élastique électriquement conductrice, apte à être maintenue en appui sur la zone de raccordement électrique de la carte à circuit imprimé, peut être agencée électriquement en contact entre l'extrémité de la paroi opposée à la plaquette de détection et une zone de raccordement électrique de la carte à circuit imprimé. Le panneau de commande peut comporter une pluralité d'éléments de détection capacitive distincts associés à une pluralité de boutons de commande capacitifs distincts.

### BREVE DESCRIPTION DES DESSINS

D'autres caractéristiques, buts et avantages de l'invention apparaîtront à la lecture de la description détaillée qui va suivre, et en regard des dessins annexés, donnés à titre d'exemple non limitatif et sur lesquels:
- La figure 1 est une vue en perspective d'un panneau de commande pour véhicule automobile selon l'invention.
- La figure 2 est une vue schématique en coupe axiale selon le plan 2-2 du panneau de commande de la figure 1.
- La figure 3 est une vue de dessus qui représente schématiquement une zone de commande illuminée du panneau de commande de la figure 1.
- La figure 4 est une vue similaire à celle de la figure 2 qui illustre l'actionnement d'un bouton capacitif du panneau de commande de la figure 1.

### DESCRIPTION DES MODES DE REALISATION PREFERES

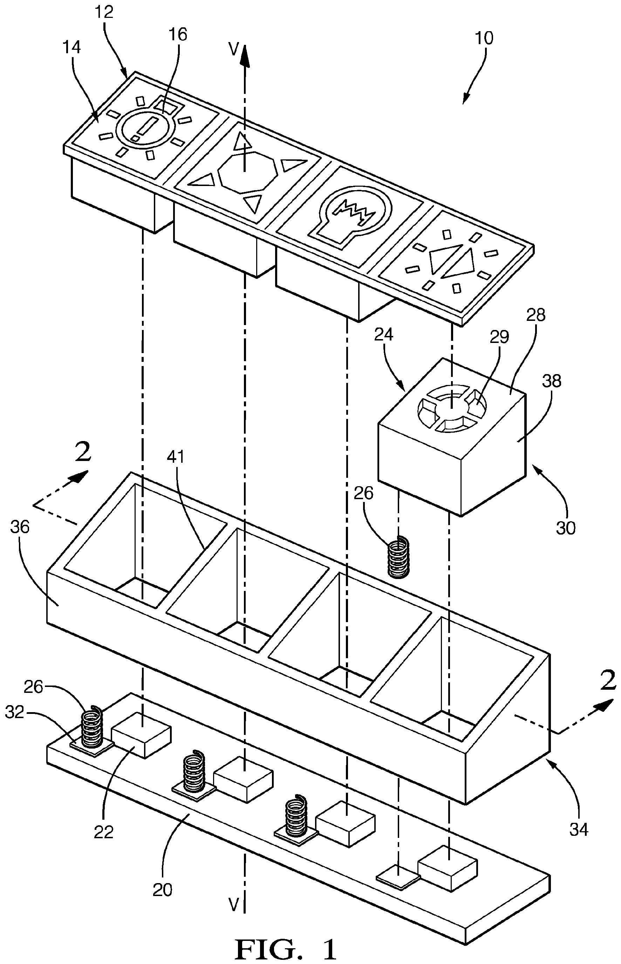

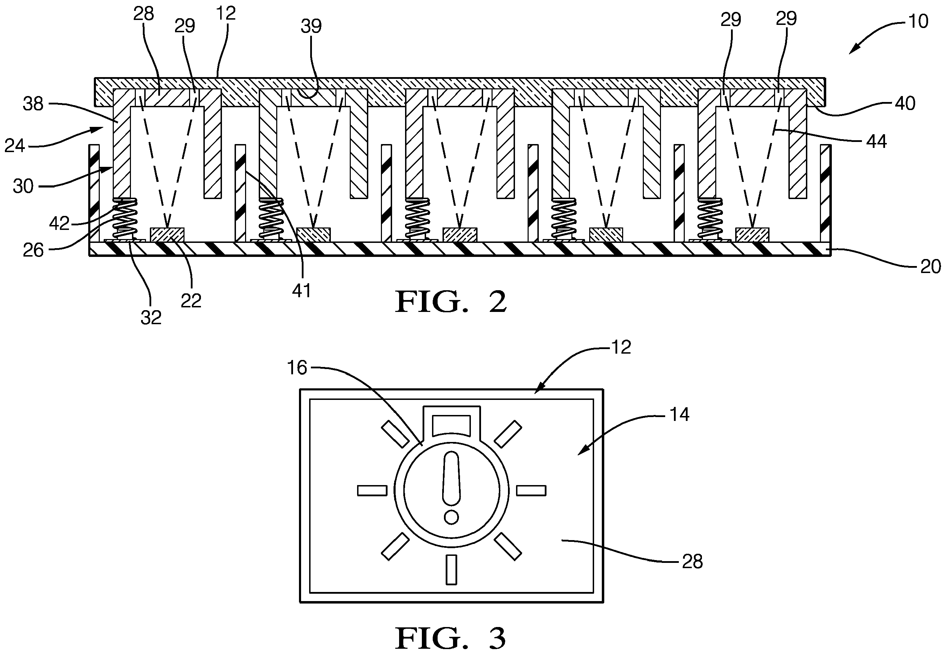

Selon la figure 1 et la figure 2, un panneau de commande 10 pour véhicule automobile comporte une façade frontale 12 comportant des pictogrammes 16. On entend par façade frontale 12, la façade du panneau de commande 10 accessible pour un utilisateur. Des éléments de détection capacitive 24 sont prévus pour être agencés contre la face arrière 40 de la façade frontale 12. De préférence, la façade frontale 12 est un élément unique recouvrant les éléments de détection capacitive 24. Alternativement, la façade frontale 12 peut être constituée d'une pluralité d'éléments recouvrant chacun un ou plusieurs éléments de détection capacitive 24. Le panneau de commande 10 comprend également une carte à circuit imprimé 20 sur laquelle sont disposées des sources de lumières 22 telles que des diodes électroluminescentes. Les diodes, les éléments de détection capacitive 24 et les pictogrammes 16 sont alignés selon un axe vertical V de sorte que les sources de lumières 22 puissent rétroéclairer les pictogrammes 16 au travers des éléments de détection capacitive 24. Des éléments élastiques électriquement conducteurs 26 représentés par des ressorts métalliques sont prévus de sorte à relier électriquement les éléments de détection 24 avec la carte à circuit imprimé 20. La carte à circuit imprimé 20 comprend des zones de raccordement électrique 32 prévues pour être en contact électrique avec les éléments élastiques électriquement conducteurs 26.

Les pictogrammes 16 indiquent des zones de commande 14 sur lesquelles un utilisateur peut appuyer afin de déclencher une fonction du véhicule. Les pictogrammes 16 peuvent être réalisés par gravures laser sur la façade frontale 12.

Chaque élément de détection capacitif 24 comprend une première partie formant une plaquette de détection capacitive 28 et une deuxième partie formant un guide de lumière 30.

La plaquette de détection 28 est adaptée pour être montée de manière adjacente à la face arrière 40 de la façade frontale 12. La plaquette de détection 28 est prévue pour permettre la détection de l'appui d'un doigt d'un utilisateur sur la zone de commande 14 en vis-à-vis. La plaquette de détection 28 est opaque et est munie d'ouvertures 29 permettant à la lumière de rétroéclairer un pictogramme 16 disposé sur la façade frontale 12, en vis-à-vis de la plaquette de détection 28. Ces ouvertures sont généralement de forme similaire au pictogramme 16 et alignées avec le pictogramme 16 suivant l'axe vertical V. La plaquette de détection 28 peut également être translucide de sorte à laisser passer la lumière. Optionnellement, la plaquette de détection 28 peut diffuser la lumière sur sa surface.

La plaquette de détection capacitive 28 est placée dans un renfoncement 39 de la face arrière 40 de la façade frontale 12. Le renfoncement 39 permet de rapprocher la plaquette de détection 28 de la zone de commande 14 de sorte à ajuster la sensibilité de détection du panneau de commande 10. En d'autre terme, la profondeur du renfoncement 39 permet de dimensionner la sensibilité de détection capacitive du dispositif. L'élément de détection 24 peut être de préférence surmoulé avec la façade frontale 12, ou collé dans le renfoncement 39. Le surmoulage permet de s'affranchir d'une étape de collage, la colle pouvant réduire la sensibilité de détection capacitive et pouvant être un obstacle à la diffusion de la lumière au travers de la plaquette de détection 28 vers le pictogramme 16.

La deuxième partie des éléments de détection capacitive 24 guide les faisceaux lumineux 44 des sources de lumière 22 vers les plaquettes de détection 28 formant ainsi les guides de lumière 30. Chaque guide de lumière 30 s'étend depuis la plaquette de détection 28 vers la carte à circuit imprimé 20.Chaque guide de lumière 30 comprend au moins une paroi 38 formant un conduit pour le faisceau lumineux 44. Tel que représenté, le guide de lumière comprend quatre parois formant un cylindre creux de forme de base rectangulaire

Alternativement le conduit peut être formé d'une cavité tel un corps cylindrique creux de forme de base circulaire, pour laquelle une seule paroi cylindrique 38 entoure le faisceau lumineux 44. La plaquette de détection 28 bouche la cavité cylindrique. La paroi 38 s'étendant depuis la plaquette de détection 28 vers la carte à circuit imprimé 20 forme le conduit de lumière. L'extrémité libre 42 de la paroi cylindrique 38 est l'extrémité de la paroi opposée à la plaquette de détection. L'extrémité libre 42 est en contact électrique avec la carte à circuit imprimé 20 par l'intermédiaire de l'élément élastique électriquement conducteur 26.

Alternativement, le conduit peut être formé de plusieurs parois 38 s'étendant depuis la plaquette de détection 28 vers la carte à circuit imprimé 20 permettant au faisceau lumineux 44 de se diriger essentiellement vers la plaquette de détection 28. Les parois interne du conduit réfléchissent la lumière et ne laissent pas la lumière se disperser en dehors du conduit.

Les éléments de détection capacitive 24 sont des pièces plastiques électriquement conductrices. Chaque élément de détection capacitif 24 est formé d'une seule pièce. De préférence ce sont des pièces formées de plastique chargée en particules métalliques telles que par exemple de la poudre ou des paillettes d'aluminium, de cuivre ou de zinc.

L'élément élastique électriquement conducteur 26 permet de relier électriquement une extrémité libre 42 du guide de lumière 30 à la carte à circuit imprimé 20. L'élément élastique électriquement conducteur 26 permet de s'affranchir des tolérances de l'assemblage du panneau de commande 10, plus particulièrement de la tolérance de la distance séparant l'élément de détection capacitive 24 avec la carte à circuit imprimé 20. L'élément élastique électriquement conducteur 26 est également apte à être fixé par soudure sur la carte à circuit imprimé 20 sur une zone de raccordement électrique 32. Il peut être envisagé de ne pas agencer d'éléments élastiques électriquement conducteurs 26. Dans ce cas de figure, une paroi 38 du guide de lumière 30 de l'élément de détection 24 a des propriétés souple et élastique de sorte à être en appui sur la zone de contact électrique 32. Il est également envisageable que l'élément de détection n'ai pas de propriétés souple et élastique lorsque les tolérances d'assemblages sont parfaitement maitrisées.

Comme représenté sur la figure 1 et la figure 2, lorsque le panneau de commande comporte une pluralité de zones de commande 14 distinctes, les éléments de détection capacitive 24 sont distants les uns des autres. Les éléments de détection capacitive 24 distincts ne sont pas directement reliés électriquement entre eux de sorte que chaque élément de détection 24 ne détecte que la commande qui lui est associée.

Bien que cela ne soit pas indispensable à l'invention, le panneau de commande 10 de la figure 1 comporte également un boîtier 34. Ce boîtier 34 est prévu pour fermer le panneau de commande 10. Le boîtier 34 comprend un bord périphérique 36 prévu pour entourer la carte à circuit imprimé 20 et s'étendant verticalement jusqu'à la façade frontale 12 de sorte à ce que la façade frontale 12 puisse fermer le boîtier 34. Le boîtier 34 comprend également des parois opaques 41 agencées sur la carte à circuit imprimé 20 et disposées entre les sources de lumière 22 de sorte à bloquer toute dispersion de lumière d'une source de lumière 22 vers une autre.

Selon la figure 3, un pictogramme 16 est rétroéclairé. Afin de faciliter les explications suivantes, la plaquette de détection 28 agencée sous la façade frontale 12 a été représentée visible à travers la zone de commande 14. Le pictogramme 16 de la zone de commande 14 est au-dessus de la surface de la plaquette de détection 28. La plaquette de détection 28 permet également une diffusion de la lumière de sorte à rétroéclairer le pictogramme 16. Par conséquent, l'avantage de l'invention est de pouvoir utiliser la totalité de la surface de la plaquette de détection 28 pour diffuser la lumière vers le pictogramme 16. Ainsi, la taille du pictogramme 16 n'est limitée que par la zone de commande 14 définie par la surface de la plaquette de détection 28. L'utilisation de l'élément de détection capacitive 24 comme guide de lumière 30 pour le rétroéclairage des pictogrammes 16 permet de résoudre un problème connu de l'art antérieur pour lequel l'élément de détection capacitive 24 est une lamelle métallique comprenant une partie adjacente à la façade frontale 12. Cette lamelle forme une électrode de détection capacitive métallique. La partie de la lamelle adjacente à la façade frontale fait obstruction au rétroéclairage de sorte que la taille du pictogramme 16 doit être réduite sur la façade frontale de sorte que le faisceau lumineux puisse rétroéclairer le pictogramme.

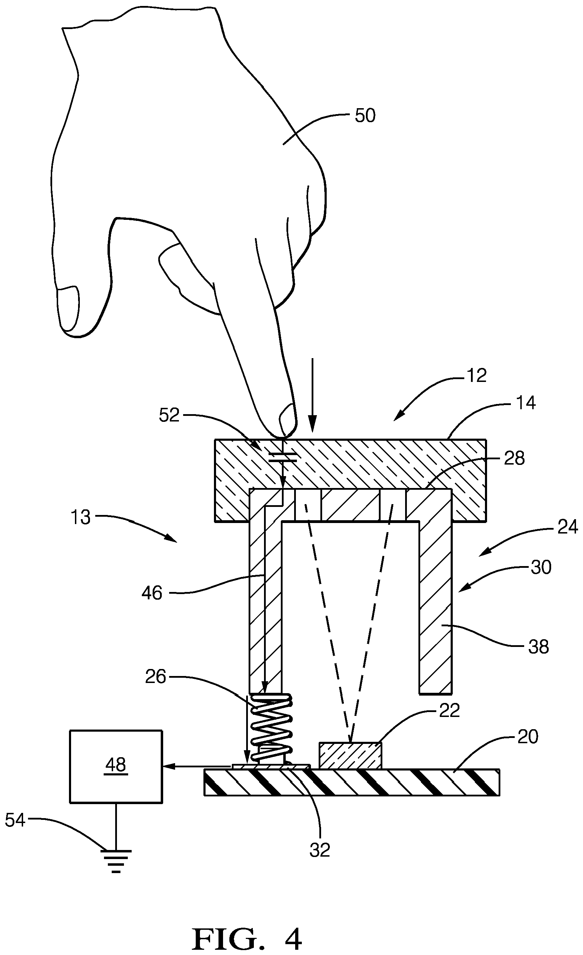

Selon la figure 4, un bouton de commande capacitif 13 comprend la zone de détection 14 localisée sur la façade frontale 12, l'élément de détection capacitive 24 agencé adjacent à la façade frontale 12 et l'élément métallique élastique 26 en connexion électrique entre la carte à circuit imprimé 20 et l'élément de détection capacitive 24. Lorsqu'un doigt 50 d'un utilisateur touche une zone de commande 14, un couplage capacitif, représenté par le symbole d'un condensateur 52, se crée entre le doigt 50 et la plaquette de détection 28. L'appui sur une zone de commande 14 crée un flux ou signal électrique 46 représenté par les flèches, depuis la façade frontale 12 jusqu'à un élément de contrôle 48 de l'élément de détection capacitive 24. Le signal électrique 46 induit de façon capacitive à travers le couplage capacitif se propage en direction d'une masse électrique 54 apportée par l'élément de contrôle 48. Le signal électrique 46 suit un chemin à travers la plaquette de détection, puis à travers une paroi 38 du guide de lumière 30 reliée électriquement à la carte à circuit imprimé 20. Le signal électrique 46 passe à travers l'élément élastique électriquement conducteur 26 qui permet d'acheminer le signal 46 vers la zone de raccordement électrique 32 de la carte à circuit imprimé 20. La zone de raccordement électrique 32 est reliée électriquement à l'élément de contrôle 48. L'élément de contrôle 48 peut être un microcontrôleur dont un port est configuré pour acquérir le signal électrique 46 de sorte que le système ainsi décrit fonctionne comme un capteur capacitif.

Optionnellement, le microcontrôleur 48 peut piloter électriquement la source de lumière 22 de sorte à synchroniser son activation ou sa désactivation en fonction de la détection ou de la non détection de l'appui sur la zone de commande 14. L'élément de contrôle 48 peut également être tout autre type d'élément de contrôle permettant de détecter la présence du signal électrique 46 généré par un couplage capacitif.

## Revendications

1. Panneau de commande (10) pour véhicule automobile comprenant
une façade frontale (12) comportant au moins un pictogramme (16) indiquant une zone de commande (14);
au moins un élément de détection capacitive (24) agencé contre la face arrière (40) de la façade frontale (12) et apposé en vis-à-vis du pictogramme (16);
une carte à circuit imprimé (20);
une source de lumière (22) montée sur la carte à circuit imprimé (20) et apte à produire un faisceau lumineux (44) de rétroéclairage vers le pictogramme ;
**caractérisé en ce que**
l'élément de détection capacitive (24) est une pièce plastique électriquement conductrice comprenant :
une première partie formant une plaquette de détection (28) adjacente à la face arrière (40) de la façade frontale (12) apte à permettre une détection capacitive sur la zone de commande (14);
une deuxième partie formant un guide de lumière (30) comprenant au moins une paroi (38) qui s'étend depuis la plaquette de détection (28) vers la carte à circuit imprimé (20) de manière à guider le faisceau lumineux (44) vers le pictogramme (16);
l'élément de détection capacitive (24) étant raccordé électriquement à la carte à circuit imprimé (20) par l'extrémité (42) de la paroi opposée à la plaquette de détection (28) ;
l'élément de détection capacitive (24) étant une seule pièce surmoulée avec la façade frontale (12).

2. Panneau de commande (10) selon l'une quelconque des revendications précédentes **caractérisé en ce que** l'élément de détection capacitive (24) est une pièce plastique chargée de particules métalliques.

3. Panneau de commande (10) selon l'une quelconque des revendications précédentes **caractérisé en ce que** le guide de lumière (30) est un conduit de lumière apte à diriger le faisceau lumineux (44) vers le pictogramme (16).

4. Panneau de commande (10) selon la revendication 3 **caractérisé en ce que** la plaquette de détection (28) est opaque et comporte au moins une ouverture (29) en vis-à-vis du pictogramme (16) apte à laisser passer la lumière vers le pictogramme (16).

5. Panneau de commande (10) selon l'une quelconque des revendications précédentes **caractérisé en ce que** la face arrière (40) de la façade frontale (12) comprend un renfoncement (39) dans lequel la plaquette de détection (28) est agencée.

6. Panneau de commande (10) selon l'une quelconque des revendications précédentes **caractérisé en ce qu'**une pièce élastique électriquement conductrice (26), apte à être maintenue en appui sur la zone de raccordement électrique (32) de la carte à circuit imprimé (20), est agencée électriquement en contact entre l'extrémité (42) de la paroi (38) opposée à la plaquette de détection (28) et une zone de raccordement électrique (32) de la carte à circuit imprimé (20).

7. Panneau de commande (10) selon l'une quelconque des revendications précédentes **caractérisé en ce qu'**il comporte une pluralité d'éléments de détection capacitive (24) distincts associés à une pluralité de boutons de commande capacitifs (13) distincts.
